Europäisches Patentamt

European Patent Office

Office européen des brevets

(19)

(11) Publication number: **0 270 562 B1**

# EUROPEAN PATENT SPECIFICATION

(45) Date of publication of patent specification: **07.10.92**

(51) Int. Cl.[5]: **H01L 29/54**, H01L 21/28

(21) Application number: **87902661.5**

(22) Date of filing: **11.05.87**

(86) International application number:
**PCT/GB87/00314**

(87) International publication number:
**WO 87/07084 (19.11.87 87/25)**

(54) **FABRICATION OF MOS-TRANSISTORS.**

(30) Priority: **12.05.86 GB 8611580**

(43) Date of publication of application:
**15.06.88 Bulletin 88/24**

(45) Publication of the grant of the patent:
**07.10.92 Bulletin 92/41**

(84) Designated Contracting States:
**DE FR IT NL**

(73) Proprietor: **PLESSEY SEMICONDUCTORS LIMITED**
**Cheney Manor**
**Swindon, Wiltshire SN2 2OW(GB)**

(72) Inventor: **BUTLER, Alan, Leonard**
**14 Willow Close Towcester**
**Northants NN12 7BO(GB)**
Inventor: **CHILDS, Peter, Anthony 21 Jordans Close**
**Boxgrove Park Guildford**
**Surrey GU1 2PB(GB)**

(74) Representative: **Nicholson, Ronald et al**
**The General Electric Co. p.l.c. Patent Department GEC-Marconi Research Centre West Hanningfield Road**
**Great Baddow, Chelmsford Essex CM2 8HN(GB)**

EP 0 270 562 B1

## Description

This invention relates to a method for the production of transistors and is particularly concerned with the fabrication of shallow $p^+$ and $n^+$ doped layers suitable for the sources and drains of submicron MOS transistors.

Shallow layers in such transistors have a very high resistance and an aim of the present invention is to reduce the resistance of such layers.

Transistors of this kind are disclosed for example by Shibata et al. in a Technical Digest, IEEE (US), of an International Electron Devices Meeting, Washington DC., 7-9 December 1981, entitled "An optimally designed process for submicron MOSFETS", pages 647-650.

According to the invention, there is provided a method of making an MOS transistor having shallow source and drain regions comprising forming on a silicon substrate a gate oxide layer extending substantially over the area of said substrate on which said transistor is to be made and surrounded by a field oxide isolating layer, applying a layer of polysilicon over said gate oxide layer and said field oxide layer, applying a resist layer over a selected region of said polysilicon layer overlying the gate oxide layer to define a gate electrode, selectively implanting doping ions through the polysilicon layer and through the gate oxide layer except in the region masked by said resist layer to form said source and drain regions, etching away the resist layer and the polysilicon layer to leave a polysilicon gate electrode extending from said gate oxide layer, activating the source and drain regions, removing the gate oxide layer over said source and drain regions, and depositing a conductive layer over said gate electrode and said source and drain regions.

By formation of doped layers to form the source and drain regions by implantation through the polysilicon layer and the gate oxide layer prior to defining the gate electrode, it is possible to achieve very shallow $p^+$ and $n^+$ doped layers which are suitable for the source and drain regions of submicron CMOS transistors.

The source and drain regions may be activated prior to etching away the polysilicon layer to define the gate electrode although it is preferred to activate said regions after the polysilicon layer had been etched away and before the gate oxide layer is removed in the source and drain regions. However, as a further alternative, activation of the dopant layers in the source and drain regions may take place after the etching away of both the polysilicon layer and the gate oxide layer.

The final conductive layer may comprise a silicide or a refractory metal deposition of, for example, tungsten.

The invention will now be further described, by way of example, with reference to the drawings which show successive steps in the production of a transistor according to the invention and in which:-

Figure 1 shows an initial stage in the process according to the invention;
Figure 2 shows the step of selective ion implantation to form shallow source and drain electrodes in the substrate;
Figure 3 shows the transistor after etching away of the polysilicon layer;
Figure 4 shows the transistor after activation of the source and drain regions; and
Figure 5 shows a completed transistor made by the process according to the invention.

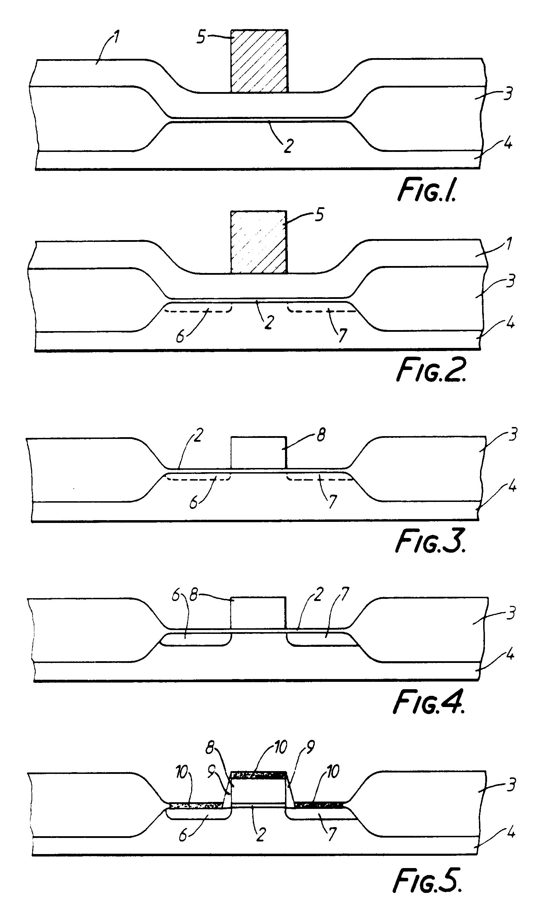

Referring to the drawings, a polysilicon layer 1 is applied over a gate oxide layer 2 which is surrounded by a field oxide isolation layer 3 located on a silicon substrate 4. A resist layer 5 is applied to the polysilicon layer 1 in a selected region of the latter overlying the gate oxide layer 2 to define a gate electrode as shown in Figure 1.

Selective n type or p type ion implantation is then carried out as shown in Figure 2, the resist layer 5 acting as a mask so that only selected regions of the substrate underlying the oxide layer 2 are implanted to form the source and drain regions of NMOS or PMOS transistors. The implants 6 and 7 just penetrate through to the active area of the device.

The polysilicon layer 1 is then etched away except in the region underlying the resist layer 5 after which the latter is removed to leave a polysilicon gate 8 as shown in Figure 3. The source and drain regions 6 and 7 are then activated and diffused to ~0.1 $\mu$m junctions depth to form the structure shown in Figure 4.

Finally, the gate oxide layer 2 is removed in the source and drain regions and gate side wall oxide fillers 9 are formed after which a silicide layer 10 is applied to the gate, source and drain regions 8, 6 and 7, to reduce the sheet resistance of the layers to ~8$\Omega$/□ or less, as shown in Figure 5.

The process according to the invention is suitable for small geometry ($\leq$ 1 $\mu$m gate length) CMOS transisters although it is considerd that it is also suitable for bipolar transistors, for example. The implantation of the sources and drains prior to defining the gate electrode enables ultra shallow diffusions to be formed.

The invention is not restricted to the above-described example but variations and modifications are possible within the scope of the claims. For example, the source and drain regions 6 and 7 may be activated prior to etching away the polysilicon layer 1 and resist 5 (Figure 3) although this is not preferred. As a further alternative, the source and drain regions 6 and 7 may be activated after the gate oxide layer 2 has been removed from these regions.

The silicide 10 may comprise polysilicon or any other suitable conductive layer. Alternatively, the silicide may be replaced be selective refractory metal deposition, e.g. selective tungsten.

## Claims

1. A method of making an MOS transistor having shallow source and drain regions (6, 7) comprising forming on a silicon substrate (4) a gate oxide layer (2) extending substantially over the area of said substrate (4) on which said transistor is to be made and surrounded by a field oxide isolating layer (3), applying a layer of polysilicon (1) over said gate oxide layer (2) and said field oxide layer (3), applying a resist layer (5) over a selected region of said polysilicon layer overlying the gate oxide layer (2) to define a gate electrode (8), selectively implanting doping ions through the polysilicon layer (1) and through the gate oxide layer (2) except in the region masked by said resist layer (5) to form said source and drain regions (6, 7), etching away the resist layer (5) and the polysilicon layer (1) to leave a polysilicon gate electrode (8) extending from said gate oxide layer (2), activating the source and drain regions (6, 7), removing the gate oxide layer (2) over said source and drain regions (6, 7), and depositing a conductive layer (10) over said gate electrode (8) and said source and drain regions (6, 7).

2. A method in accordance with Claim 1 wherein the gate oxide layer (2) over said source and drain regions (6, 7) is removed before said source and drain regions (6, 7) are activated.

3. A method according to Claim 1 or Claim 2 wherein the conductive layer (10) comprises a silicide.

4. A method according to Claim 1 or Claim 2 wherein the conductive layer (10) comprises a refractory metal.

5. A method according to any preceding claim wherein the gate electrode (8) is provided with oxide fillets (9) prior to the deposition of said conductive layer (10).

## Patentansprüche

1. Verfahren zum Herstellen eines MOS Transistors, der flache Source- und Drainbereiche (6,7) aufweist, umfassend das Ausbilden einer Gate-Oxidschicht (2) auf einem Substrat (4), wobei sich die Gate-Oxidschicht im wesentlichen über den Bereich des Substrats (4) erstreckt, auf dem der Transistor herzustellen ist, und von einer isolierenden Feldoxidschicht (3) umgeben ist, das Aufbringen einer Schicht aus Polysilizium (1) über der Gate-Oxidschicht (2) und der Feldoxidschicht (3), das Aufbringen einer Abdeckschicht (5) über einer ausgewählten Region der über der Gate-Oxidschicht (2) liegenden Polysiliziumschicht zum Definieren einer Gateelektrode (8), das selektive Implantieren von Dotierionen durch die Polysiliziumschicht (1) und durch die Gate-Oxidschicht (2) außer in der durch die Abdeckschicht (5) maskierten Region zur Ausbildung der Source- und Drainbereiche (6,7), Wegätzen der Abdeckschicht (5) und der Polysiliziumschicht (1), um eine sich von der Gate-Oxidschicht (2) ertreckende Polysilizium-Gateelektrode (8) zurückzulassen, Aktivieren der Source- und Drainbereiche (6,7), Entfernen der Gate-Oxidschicht (2) über den Source- und Drainbereichen (6,7) und Abscheiden einer leitenden Schicht (10) über der Gateelektrode (8) und den Source- und Drainbereichen (6,7).

2. Verfahren nach Anspruch 1, in welchem die Gate-Oxidschicht (2) über den Source- und Drainbereichen (6,7) entfernt wird, bevor die Source- und Drainbereiche (6,7) aktiviert werden.

3. Verfahren nach Anspruch 1 oder 2, in welchem die leitende Schicht (10) ein Silicid umfaßt.

4. Verfahren nach Anspruch 1 oder Anspruch 2, in welchem die leitende Schicht (10) ein hochschmelzendes Metall umfaßt.

5. Verfahren nach einem vorhergehenden Anspruch, in welchem die Gatelektrode (8) vor der Abscheidung der leitenden Schicht (10) mit Oxidleisten (9) versehen wird.

## Revendications

1. Procédé de fabrication d'un transistor MOS présentant des régions source et drain (6, 7) peu profondes, procédé consistant à former, sur un substrat de silicium (4), une couche (2) d'oxyde de grille, s'étendant sensiblement sur la zone dudit substrat (4) sur laquelle ledit transistor doit être fabriqué et entourée par une couche isolante (3) d'oxyde épais, à appliquer une couche de polysilicium (1) par-dessus ladite couche (2) d'oxyde de grille et ladite couche (3) d'oxyde épais, à appliquer une couche de réserve (5) par-dessus une région sélectionnée de ladite couche de polysilicium surmontant la couche (2) d'oxyde de grille pour définir une électrode de grille (8), à implanter sélectivement des ions dopants à travers la couche de polysilicium (1) et à travers la couche (2) d'oxyde de grille, à l'exception de la région masquée par ladite couche de réserve (5) pour former ladite région source et ladite région drain (6, 7), à éliminer, par attaque chimique, la couche de réserve (5) et la couche de polysilicium (1) pour laisser une électrode de grille de polysilicium (8) s'étendant à partir de ladite couche (2) d'oxyde de grille, à activer la région source et la région drain (6, 7), à enlever la couche (2) d'oxyde de grille qui se trouve par-dessus ladite région source et ladite région drain (6, 7) et à déposer une couche conductrice (10) pardessus ladite électrode de grille (8) et par-dessus ladite région source et ladite région drain (6, 7).

2. Procédé selon la revendication 1, dans lequel on enlève la couche (2) d'oxyde de grille qui se trouve pardessus ladite région source et ladite région drain (6, 7) avant d'activer ladite région source et ladite région drain (6, 7).

3. Procédé selon la revendication 1 ou la revendication 2, dans lequel la couche conductrice (10) comprend, ou est formée par, un siliciure.

4. Procédé selon la revendication 1 ou la revendication 2, dans lequel la couche conductrice (10) comprend, ou est formée par, un métal réfractaire.

5. Procédé selon l'une quelconque des revendications précédentes, dans lequel on munit l'électrode de grille (8) de flancs de raccord (9) avant le dépôt de ladite couche conductrice (10).

Fig.1.

Fig.2.

Fig.3.

Fig.4.

Fig.5.